# EUROPEAN PATENT APPLICATION

(11) **EP 2 219 424 A1**
(43) Date of publication of application: **18.08.2010**
(21) Application number: 10158080.1
(22) Date of filing: 19.08.2008
(51) Int. Cl.: H05K 1/02, H01C 7/10

(54) **Voltage switchable dielectric material incorporating modified high aspect ratio particles**

(30) Priority: 20.08.2007 US 956860 P; 18.08.2008 US 193603
(62) Divisional of application: 08798196.5
(71) Applicant: Shocking Technologies Inc, San Jose, California 95119-1926 (US)
(72) Inventor: Kosowsky, Lex, San Jose CA 95138 (US); Fleming, Robert, San Jose CA 95119-1926 (US); Wu, Junjun, Woodbury Minnesota 55125 (US)
(74) Representative: Potter, Julian Mark

(57) **Abstract**

Embodiments described herein provide for a composition of voltage switchable dielectric (VSD) material that includes a concentration of modified high-aspect ratio (HAR) particles. In an embodiment, at least a portion of the concentration includes HAR particles are surface-modified to provide core-shell HAR particles. As an alternative or addition, a portion of the concentration includes HAR particles that are surface-modified to have activated surfaces.

## Description

### RELATED APPLICATIONS

This application claims priority to U.S. Patent Application No. 12/193,603 filed August 18, 2008, entitled "Voltage Switchable Dielectric Material Incorporating Modified High Aspect Ratio Particles; which claims benefit of priority to provisional U.S. Patent Application No. 60/956,860 filed August 20, 2007, entitled "Voltage Switchable Dielectric Material Incorporating Surface-Modified Particles"; the aforementioned applications being hereby incorporated by reference in their entirety.

### TECHNICAL FIELD

The disclosed embodiments relate generally to the field of voltage switchable dielectric (VSD) materials. More specifically, embodiments described herein include VSD material that includes high aspect ratio particles.

### BACKGROUND

Voltage switchable dielectric (VSD) material has an increasing number of applications. These include its use on, for example, printed circuit boards and device packages, for purpose of handling transient voltages and electrostatic discharge events (ESD).

Various kinds of conventional VSDM exist. Examples of voltage switchable dielectric materials are provided in references such as U.S. Pat. No. 4,977,357, U.S. Pat, No. 5,068,634, U.S. Pat. No. 5,099,380, U.S. Pat. No. 5,142,263, U.S. Pat. No. 5,189,387, U.S. Pat. No. 5,248,517, U.S. Pat. No. 5,807,509, WO 96/02924, and WO 97/26665. VSD material can be "SURGX" material manufactured by the SURGX CORPORATION (which is owned by LITTLEFUSE, INC.).

While VSD material has many uses and applications, conventional compositions of the material have had many shortcomings. Typical conventional VSD materials are brittle, prone to scratching or other surface damage, lack adhesive strength, and have a high degree of thermal expansion.

### BRIEF DESCRIPTION OF THE DRAWINGS

FIG. 1 is an illustrative sectional view of a layer or thickness of VSD material including different classes of particles as constituents, under an embodiment.

FIG. 2 illustrates use of a core-shell structure for HAR particle constituents in a composition of VSD material, under an embodiment.

FIG. 3 illustrates a simplified diagram of a surface-modified HAR particle, under one or more embodiments.

FIG. 4 is another simplified diagram depicting functionalization of surface-modified HAR particles, under an embodiment.

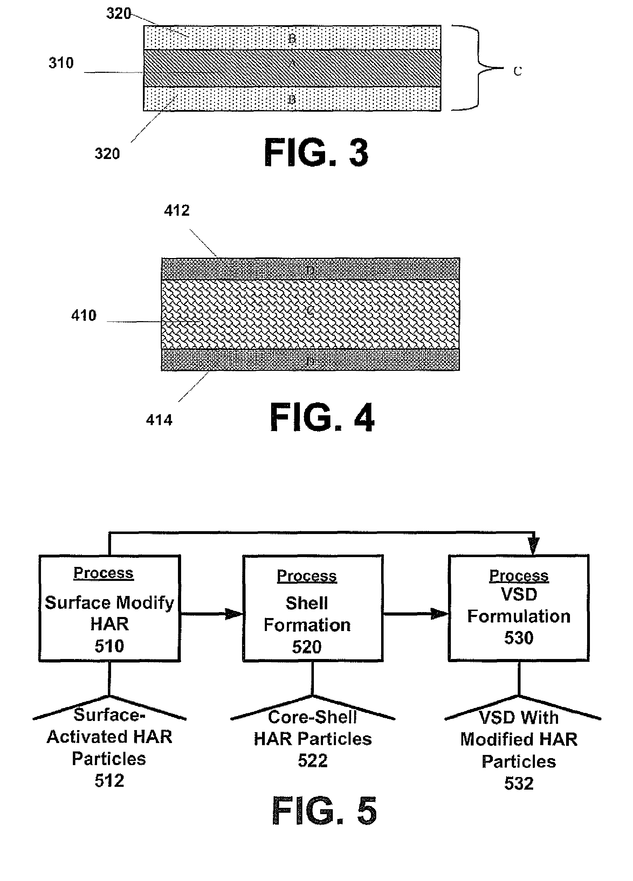

[0009] FIG. 5 illustrates processes for forming VSD material with a composition that includes modified HAR particles, under an embodiment.

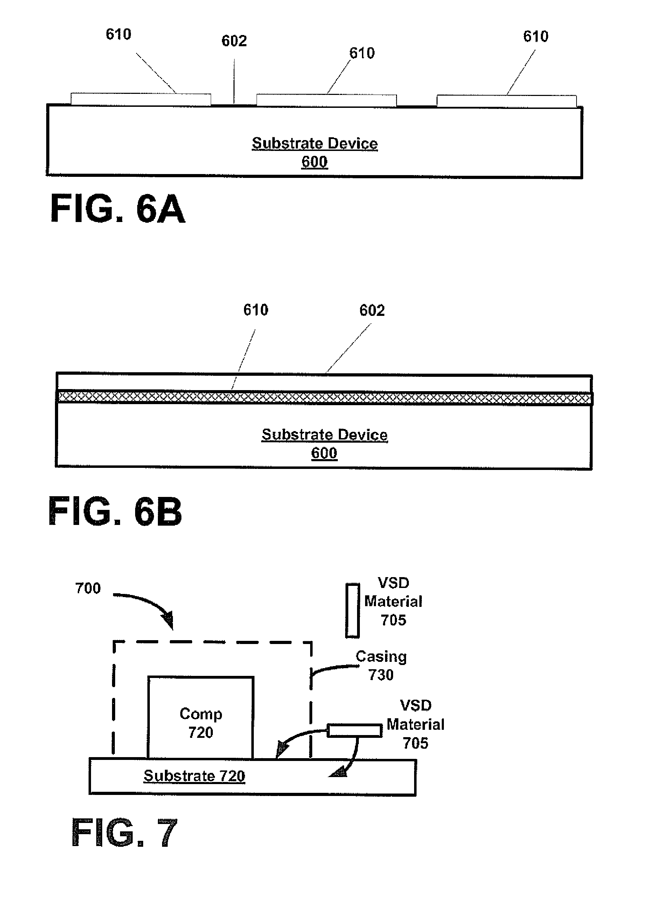

FIG. 6A and FIG. 6B each illustrate different configurations for a substrate device that is configured with VSD material having a composition such as described with any of the embodiments provided herein.

FIG. 7 is a simplified diagram of an electronic device on which VSD material in accordance with embodiments described herein may be provided.

### DETAILED DESCRIPTION

Embodiments described herein provide for a composition of voltage switchable dielectric (VSD) material that includes a concentration of modified high-aspect ratio (HAR) particles. In an embodiment, at least a portion of the concentration includes HAR particles that are surface-modified to provide core-shell HAR particles. As an alternative or addition, a portion of the concentration includes HAR particles that are surface-modified to have activated surfaces when dispersed in a composition of VSD material.

Accordingly, embodiments provide for a composition of VSD material that includes a binder or matrix, and particle constituents that include nano-dimensioned (i.e. "nano-scaled") HAR particles. The HAR particles may be comprised of conductive or semi-conductive materials.

In this application, nanoscale particles are particles for which a smallest dimension (e.g. diameter or cross-section) is less than 500 nanometers. One or more embodiments provide for nano-dimensioned or nanoscale particles as having a smallest dimension that is less than 100nm, and still further, other embodiments provide for a smallest dimension that is less than 50nm. Examples of such particles include carbon nanotubes or graphenes, although numerous other kinds of particles are contemplated. Carbon nanotubes are examples of super HAR particles, with aspect ratios of an order of 1000:1 and more. Materials with lesser aspect ratios are also contemplated as an alternative or addition to carbon nanotubes, including one or more of carbon black (L/D of order of 10:1) particles and carbon fiber (L/D of an order of 100:1) particles.

According to embodiments described herein, the constituents of VSD material include nano-dimensioned HAR particles, of which some are uniformly mixed into a binder or polymer matrix. In one embodiment, the HAR particles are dispersed into the mixture at nanoscale, meaning the particles that comprise the conductive/semi-conductive material are (i) nanoscale in at least one dimension (e.g. cross-section), and (ii) a substantial number of the particles that comprise the overall dispersed quantity in the volume are individually separated (so as to not be agglomerated or compacted together).

As used herein, "voltage switchable material" or "VSD material" is any composition, or combination of compositions, that has a characteristic of being dielectric or non-conductive, unless a field or voltage is applied to the material that exceeds a characteristic level of the material, in which case the material becomes conductive. Thus, VSD material is a dielectric unless voltage (or field) exceeding the characteristic level (e.g. such as provided by ESD events) is applied to the material, in which case the VSD material is switched into a conductive state. VSD material can further be characterized as a nonlinear resistance material. With an embodiment such as described, the characteristic voltage may range in values that exceed the operational voltage levels of the circuit or device several times over. Such voltage levels may be of the order of transient conditions, such as produced by electrostatic discharge, although embodiments may include use of planned electrical events. Furthermore, one or more embodiments provide that in the absence of the voltage exceeding the characteristic voltage, the material behaves similar to the binder.

Still further, an embodiment provides that VSD material may be characterized as material comprising a binder mixed in part with conductor or semi-conductor particles. In the absence of voltage exceeding a characteristic voltage level, the material as a whole adapts the dielectric characteristic of the binder. With application of voltage exceeding the characteristic level, the material as a whole adapts conductive characteristics.

As described with numerous embodiments, an electronic device may be equipped or provided with VSD material to facilitate the handling of Electrostatic Discharge (ESD) events and electrical overstress (EOS)conditions. Such electrical devices may include substrate devices, such as printed circuit boards, semiconductor packages, discrete devices, Light Emitting Diodes (LEDs), and radio-frequency (RF) components.

OVERVIEW

Embodiments described herein provide for different compositions of VSD material that includes different classes of kinds of particle constituents. In particular, embodiments include VSD material that has classes of particles that vary in dimension and type. One class of particles provided for use in composition of VSD material includes HAR particles, such as graphenes, carbon nanotubes, metal rods or nanowires, as well as conductive metal oxide nano rods or nanowires. As described below, this class of particles may be surface-modified and optionally provided shell material to form a constituent particle class of the VSD material.

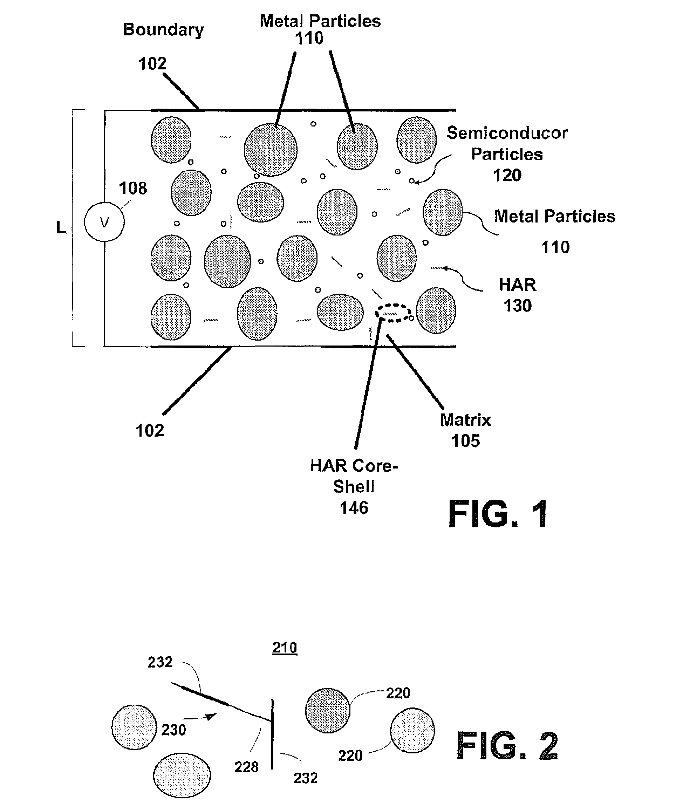

FIG. 1 is an illustrative sectional view of a layer or thickness of VSD material that includes different classes of particles as constituents, under an embodiment. A layer of VSD material 100 includes a matrix 105 having dispersed particles of various types and dimensions. The matrix 105 may be comprised of a polymer. According to an embodiment, the classes of particle constituents of the VSD material 100 include (i) metal (or conductive) particles 110, (ii) semiconductor particles 120, and (iii) high-aspect ratio (HAR) particles 130. The HAR particles 130 may be organic (e.g. carbon nanotubes) or inorganic (e.g. nano-wires), and may be dispersed between the other particles at various concentrations. The articles may be dispersed in a matrix 105, and formulated so as to have electrical characteristics that define voltage-switchable dielectric material.

As will be described, embodiments provide that at least a portion of the HAR particles dispersed in the VSD material is surface-modified. The core-shell particle 146 illustrate HAR particles 130 that are modified and/or provided with material that forms a shell about the particle core. Surface-modified or core-shell HAR particles form at least a portion of the overall concentration level of the particle class.

The dispersion of the various classes of particles in the matrix 105 may be such that the VSD material 100 is non-layered and uniform in its composition, while exhibiting electrical characteristics of voltage switchable dielectric material. Generally, the characteristic voltage of VSD material is measured at volts/length (e.g. per 5 mil), although other field measurements may be used as an alternative to voltage. Accordingly, a voltage 108 applied across the boundaries 102 of the VSD material layer may switch the VSD material 100 into a conductive state if the voltage exceeds the characteristic voltage for the gap distance L. One or more embodiments provide that VSD material has a characteristic voltage level that exceeds that of an operating circuit. As mentioned, other characteristic field measurements may be used.

SURFACE-MODIFIED HAR PARTICLES

As with other embodiments, the use of surface-modified HAR particles in VSD material, both with and without shell formations, has numerous advantages. Among benefits, higher loading fraction of HAR particles with significant reduction in loading fraction of other low aspect ratio (LAR) particles can be achieved. Still further, as the fraction of matrix material increases, the durability and flexibility of the final product improves. Additionally, the leakage current at biases below the switching voltage may decrease. With regard to some embodiments, higher off-state resistance for certain applications can be obtained by forming a semiconducting or insulating junction on the HAR particle surface.

FIG. 2 illustrates use of a core-shell structure for HAR particle constituents in a composition of VSD material, under an embodiment. In particular, as an addition or alternative to embodiments described above, the composition of VSD material 200 may include surface-modified HAR particles 230, each of which include HAR particle cores 228 and appropriately dimensioned shell material 232. The surface-modified HAR particles 230 may comprise some or all of the total number of HAR particles dispersed in the binder or matrix (not shown) of the VSD material 200. The core-shell HAR particles 230 may form one constituent, combined with conductor particles and/or semiconductor particles 220.

The HAR particles 230 that are included as constituents of the VSD material may be conductive or semiconductive. Some examples of HAR particles include carbon nanotubes, and nano-dimensioned metal rods and wires. More specific examples of the different types of HAR particles for use with embodiments described herein include CNT or multi-wall carbon nanotube (MWCNT) as mentioned in recited examples, as well as zinc oxide (ZnO), aluminum doped zinc oxide (AZO), antimony doped tin oxide (ATO), indium doped tin oxide (ITO) and other conductive metal oxides; aluminum (Al), gold (Au), silver (Ag), copper (Cu), nickel (Ni) and other metal particles; silicon (Si), germanium (Ge), gallium arsenide (GaAs), gallium phosphide (GaP) and other undoped and doped semiconductor particles.

According to embodiments described herein, core-shell HAR particles are provided a barrier that enables VSD material to be designed and tuned for desired electrical characteristic. The use of HAR particles in the composition of VSD material can reduce undesirable electrical characteristics, such as leakage current, lower clamp voltage and provide better mechanical characteristics. The use of core-shell HAR particles can provide added ability to tune or enhance electrical characteristics by providing a molecular interface between individual HAR particles and other constituents of the VSD material, In one embodiment, HAR particles may be selected to be conductive, and shell material may be selected to be semiconductive. The material may form varistor elements as constituents in the VSD material. The estimated energy barrier formed by the shells of HAR particles, as well as the number/size of the interface, can be adjusted to control the varistor properties for different application requirements. Due to the nanometer size scale of such interfaces compared to conventional commercial varistor (for example ZnO varistor), the size and weight of the varistor can thus be reduced.

As described below, the "diode-like" behavior of the interface/junction between HAR particle and surface bound/attached semiconducting particles (inorganic or organic) can enable compositions of VSD material for various electronic devices, such as light emitting diodes (LEDs), solar cells, transistors, memories, and batteries.

Among other benefits, use of core-shell HAR particles enables higher loading fraction of HAR particles with significant reduction in loading fraction of other low aspect ratio (LAR) particles. As the fraction of matrix material increases, the durability and flexibility of the final product improve. Other benefits may include reduction in leakage current at biases below the switching voltage, so as to create higher off-state resistance for certain applications, Better thermal management and heat dissipation can be realized due to less resistive heating from the VSD materials during operation by plating the HAR particle surface with metals. Due to overall reduced amount of particle loading fraction, the dielectric constant of the VSD materials may also be reduced. Higher HAR loading levels also increase current carrying capacity resulting in lower clamp voltages.

FIG. 3 illustrates a simplified diagram of a surface-modified HAR particle, under one or more embodiments. In an embodiment, a representative HAR particle 310 is shown with surface coating 320 in the form surface functional groups such as -COOH, -SH, -OH, -Cl or mixture thereof, coated on the surface of the HAR particle Electronic charges can exist simultaneously with the chemical functional groups. The surface coverage of coating 320 can be adjusted to suit applications.

FIG. 4 is another simplified diagram depicting functionalization of surface-modified HAR particles, under an embodiment. FIG. 4 shows a representative HAR particle 410 is surface-modified to include coatings 412, 414. HAR particle as in Figure 1 consisting of A and B. The coatings 412, 414 may differ or be the same, and may include any one or mixture of the following materials: inorganic nano particles, nano wires, nano rods, nano shells, including conducting, semiconducting, insulating materials, organic small molecules, oligomeric polymers, polymers, including conducting, semiconducting, and/or insulating materials.

[032] FIG. 5 illustrates processes for forming VSD material with a composition that includes modified HAR particles, under an embodiment. The modification to the HAR particles may correspond to either modifying the surfaces of HAR particles, or forming shell material on the surfaces of the modified HAR particles. According to an embodiment, the processes for forming a composition of VSD material, including modified HAR particles as its constituents, includes performance of steps that comprise surface modification 510, shell formation process 520, and VSD formulation process 530.

In a surface modification process 510, a concentration of HAR particles that are to be constituents in a composition of VSD material are subjected to a medium that activates a surface of individual HAR particles in the concentration. A result of surface modification process 510 is the formation of surface-modified (i.e. activated) HAR particles 512. The surface modification may serve to (i) enhance the wettability of the HAR particles in a matrix (that is to be formed into VSD material), thereby enhancing dispersion of the HAR particles; or (ii) enable the HAR particles to bond with shell materials so as to form core-shell structures. In an embodiment, the medium corresponds to an acidic solvent that can create the desired surface-modification. In one embodiment, the solvent is water based peroxide, in another embodiment the surface modification takes place in a gas plasma (such as air, nitrogen, argon, helium, fluorine, or oxygen gas).

With regard to dispersion or wettability, the dispersion of the HAR particles uniformly in the matrix of VSD material enhances the properties of the VSD material and improves desirable characteristics. The polarity of the surface-modified particles may be selected or designed for compatibility with the matrix to further enhance results. Embodiments provide that surface-modified HAR particles 512 may be applied into the matrix of VSD material and formulated into VSD material without forming the particles into core-shells. Thus, according to an embodiment, the VSD formulation process 530 follows surface modification process 510, using surface-modified HAR particles 512, and no shell formation is formed on the HAR particles 512.

Optionally, shell formation process 520 provides that the surface-modified HAR particles are subjected to sub-processes or steps for the formation of shell material. In one implementation, process 520 is performed as a separate process from activating the surface of the HAR particles. In another implementation, surface modification process 510 and shell formation 520 are performed as one process, so that activation of surfaces of a concentration of HAR particles occurs using the same medium or process as forming the shell material. As described with examples detailed below, shell formation process 520 may correspond to subjecting HAR particles to, for example, a liquid medium or deposition process. The result of shell formation process 520 is the creation of a concentration of core-shell HAR particles 522.

Following surface modification process 510 or shell formation process 520 (core-shell formation of HAR particles), the modified HAR particles are combined into the matrix of the VSD material in the VSD formulation process 530. The VSD formulation process 530 may include filtering, rinsing, and drying (repeatedly if necessary) the matrix of HAR-carrying mediums. In some implementations, the step of drying HAR particles includes sintering. Processes such as described in U.S. Patent Applications No. 11/829,946 (entitled VOLTAGE SWITCHABLE DIELECTRIC MATERIAL HAVING CONDUCTIVE OR SEMI-CONDUCTIVE ORGANIC MATERIAL; filed July 29, 2007; and hereby incorporated by reference in this application) and U.S. Patent Applications No. 11/829,948 (VOLTAGE SWITCHABLE DIELECTRIC MATERIAL HAVING HIGH ASPECT RATION PARTICLES; and hereby incorporated by reference in this application) may also be performed to formulate the resulting VSD material to include the desired type of modified HAR particles.

As an alternative to step 510, surface-modified HAR particles may be purchased from commercially available sources. For example, surface-modified carbon nanotubes may be purchased under the trade name of OH OR COOH FUNCTIONALIZED CNT, manufactured by CHEAP TUBES, INC.

The following provide examples of a production process such as described with an embodiment of FIG. 5.

MWCNT is treated with HNO₃ (510). After HNO₃ treatment, the surface of MWCNT becomes more polar and hydrophilic. The treated MWCNT is then used directly in the composite formulation. (530) Among other benefits, less time is needed to adequately disperse the MWCNT in the matrix due to enhanced compatibility/wetting of surface-modified MWCNT with matrix materials and polar solvents used.

The reactive functional groups such as -COOH and -OH on the surface of MWCNT formed during the treatment can further bind to various particles' surface by either covalent bonds or electrostatic interaction (520), Such particles may include, for example, TiO₂, ZrO₂, Al₂O₃, CeO₂, Bi₂O₃, ZnO, WO₃, TiN, TiB₂, BaTiO₃ all of which can be used as ingredients in the VSD material, to form intimate electrical contacts and potential barriers beneficial to the nonlinear electrical properties required by VSD material. Other processes may be used to subject HAR particles to being provided various functional coatings on the particle surface. These other processes include atomic layer deposition (ALD), vapor deposition, plasma deposition, sputtering, electro-deposition. The HAR CORE particles consist of MWCNT as mentioned above, as well as zinc oxide (ZnO), aluminum doped zinc oxide (AZO), antimony doped tin oxide (ATO), indium doped tin oxide (ITO) and other conductive metal oxides; aluminum (Al), gold (Au), silver (Ag), copper (Cu), nickel (Ni) and other metal particles; silicon (Si), germanium (Ge), gallium arsenide (GaAs), gallium phosphide (GaP) and other undoped and doped semiconductor particles.

More generally, HAR particles such as metal rods or wires may be subjected to acid-based solvents, based on the type of metal or conductor present on the HAR particle.

An additional or alternative, functional coatings can also be formed directly on the surface of the HAR particles that undergo surface-treatment (e.g. subjected to acid solvent). As an example, 10g MWCNT may be mixed with 200mL 68%wt HNO₃ (510) acid. The mixture is refluxed in oil bath at 140C for six hrs. After cooling down to 90°C, 100mL 3 molar TiCl₄ aqueous solution is added rapidly into the MWCNT reaction vessel, forming shell material about the HAR particle. (520) After reacting at 90°C for another six hrs the mixture is filtered and rinsed with DI water and ethanol. The final product is dried in vacuum at 100°C overnight and used in the formulation of VSD material (530). As an alternative to carbon nanotubes, other HAR particles may be subjected to similar processes taking into account appropriate activation elements specific to the type of HAR particle being used.

An additional or optional step, colloidal particle precursor solutions can also be used to modify the HAR particle surface. For example, after surface-modification (e.g. through acid-based solvent, as described with 510) colloidal particle precursor solutions may be mixed with the HAR particle solution. Further reaction between the modified HAR particle and the colloidal particles occurs to bind the particles to the HAR particle surface. The final reaction product is then filtered, washed and dried, for use in formulating VSD material (530). The colloidal particles can be conductive, semiconducting or insulating. Nanoparticle particle colloidal dispersions that can be used include those of, for example, titanium dioxide, tin dioxide, antimony doped tin dioxide, zinc oxide, nickel oxide, copper oxide. The colloidal particle solutions are readily available either commercially or through simple chemical reactions. As an example, 12mL 1M NiSO₄ solution may be mixed with 9mL 0.2M K₂S₂O₈ solution and 6mL DI water. Next, 5g of the acid treated HAR MWCNT is added to the above solution and mixed with a magnetic stirrer and dispersed (e.g. with a sonicator). After 10 to 15 minutes, 2.4mL NH₄OH solution (30%wt) is added quickly under vigorous stirring. The mixture is further mixed for four hours at room temperature. Colloids may form. After filtering and rinsing with DI water and ethanol for several times, the filtered powder is dried at 100°C in vacuum for 2 hour. The dried powder is finally heated in a furnace at elevated temperature to convert the adsorbed nickel hydroxide to an oxide surface layer on the MWCNT.

As an additional alternative step following surface modification (510), another embodiment provides for process 520 to include use of a separate organo-metalic precursor solution to form the shell material. In one embodiment, sol-gel precursor chemicals is used to modify the HAR particle surface. In one implementation, 50mL of titanium tetraisopropoxide is mixed with 250mL of 2-methoxyethanol and 25mL of ethanolamine. While under argon flow, the mixture is heated at 80°C and 120°C for 1 hour each and repeated once. The resulting product is used as the titanium oxide precursor solution to coat acid treated MWCNT. As an example, 20g of the above titanium oxide precursor solution is mixed with 50g of isopropanol, Then 10g of nickel acid treated MWCNT powder is added under vigorous stirring by magnetic stirrer and sonicated at the same time. After sonicating (or mixing) for 60 minutes, the sonicator horn is removed. Most of the volatile solvent is then removed by mixing with stirrer and heating at 70°C for several hours. The mixture is placed in an oven at 80°C until all solvents evaporate. The dried powder is then heated at elevated temperature to convert sol-gel precursor coating to titanium oxide coating.

As still another alternative or addition for step 520, small organic molecule, oligomeric polymers, and/or polymers that are compatible or reactive with the surface functional groups on the HAR particles, can be added to the HAR particle reaction vessel. Block-copolymer can be used to improve the dispersion of HAR particles and induce ordered distribution of ingredients in the formulation under appropriate conditions. For example block-copolymer can help to control the spacing among the ingredients in the VSD material if self organization process takes place. These organic materials can also be applied to surface-modified HAR particles and/or core-shelled HAR particles to improve dispersion and distribution of said particles in the VSD materials, Appropriate processing, such as filtration and removal of reaction solvent, may be performed to enable resulting materials use in the VSD composition.

As still another alternative or addition, organic conducting or semiconducting polymer can be used to form nanostructured electronic interfaces and structures to improve the electrical performance of the VSD materials.

Still further, HAR particles may be surface-modified through electroless plating. In an embodiment, electroless plating may be used to modify HAR particle surface to adjust the surface conductivity of the material. In one example, commercial copper plating solution may be used to electrolessly plate copper on ATO nanorods surface, In another example, commercial nickel plating solution may be used to electrolessly plate nickel on ATO nanorods surface. The metal plated ATO nanorods are then used in the formulation of the VSD materials.

As still another variation, surface-modified and/or coated surfaces of HAR particles can be further modified with functional groups that can form covalent bonds with molecules of the polymer matrix of the VSD material. As a result the mechanical property and compatibility of the VSD materials can be further enhanced.

ALTERNATIVES

While numerous techniques have been disclosed to surface-modify HAR particles, other embodiments may incorporate use of such techniques (or combination of portions thereof) to modify other particles that comprise a constituent class of the VSD material. In particular, surface-modification techniques may be implemented to modify nano-dimensioned particles that are not necessarily HAR particles (e.g. aspect ration of less than 5). As an alternative or addition, larger particles in the constituent class of VSD material may also be surface-modified using techniques or combinations described herein.

VSD MATERIAL APPLICATIONS

Numerous applications exist for compositions VSD material in accordance with any of the embodiments described herein. In particular, embodiments provide for VSD material to be provided on substrate devices, such as printed circuit boards, semiconductor packages, discrete devices, as well as more specific applications such as LEDs and radio-frequency devices (e.g. RFID tags). Still further, other applications may provide for use of VSD material such as described herein with a liquid crystal display, organic light emissive display, electrochromic display, electrophoretic display, or back plane driver for such devices. The purpose for including the VSD material may be to enhance handling of transient and overvoltage conditions, such as may arise with ESD events. Another application for VSD material includes metal deposition, as described in U.S. Patent No. 6,797,145 to L. Kosowsky (which is hereby incorporated by reference in its entirety).

FIG. 6A and FIG. 6B each illustrate different configurations for a substrate device that is configured with VSD material having a composition such as described with any of the embodiments provided herein. In FIG. 6A, the substrate device 600 corresponds to, for example, a printed circuit board. In such a configuration, VSD material 610 (having a composition such as described with any of the embodiments described herein) may be provided on a surface 602 to ground a connected element. As an alternative or variation, FIG. 6B illustrates a configuration in which the HAR particles VSD forms a grounding path within a thickness 610 of the substrate.

ELECTROPLATING

In addition to inclusion of the VSD material on devices for handling, for example, ESD events, one or more embodiments contemplate use of VSD material (using compositions such as described with any of the embodiments herein) to form substrate devices, including trace elements on substrates, and interconnect elements such as vias. U.S. Patent No. 6,797,145 (incorporated herein in its entirety) recites numerous techniques for electroplating substrates, vias and other devices using VSD material. Embodiments described herein enable use of VSD material, as described with any of the embodiments in this application.

OTHER APPLICATIONS

FIG. 7 is a simplified diagram of an electronic device on which VSD material in accordance with embodiments described herein may be provided. FIG. 7 illustrates a device 700 including substrate 710, component 720, and optionally casing or housing 730. VSD material 705 (in accordance with any of the embodiments described) may be incorporated into any one or more of many locations, including at a location on a surface 702, underneath the surface 702 (such as under its trace elements or under component 720), or within a thickness of substrate 710. Alternatively, the VSD material may be incorporated into the casing 730. In each case, the VSD material 705 may be incorporated so as to couple with conductive elements, such as trace leads, when voltage exceeding the characteristic voltage is present. Thus, the VSD material 705 is a conductive element in the presence of a specific voltage condition.

With respect to any of the applications described herein, device 700 may be a display device. For example, component 720 may correspond to an LED that illuminates from the substrate 710. The positioning and configuration of the VSD material 705 on substrate 710 may be selective to accommodate the electrical leads, terminals (i.e. input or outputs) and other conductive elements that are provided with, used by or incorporated into the light-emitting device. As an alternative, the VSD material may be incorporated between the positive and negative leads of the LED device, apart from a substrate. Still further, one or more embodiments provide for use of organic LEDs, in which case VSD material may be provided, for example, underneath the OLED.

With regard to LEDs, any of the embodiments described in U.S. Patent Application No. 11/562,289 (which is incorporated by reference herein) may be implemented with VSD material such as described with other embodiments of this application.

Alternatively, the device 700 may correspond to a wireless communication device, such as a radio-frequency identification device. With regard to wireless communication devices such as radio-frequency identification devices (RFID) and wireless communication components, VSD material may protect a component 720 from, for example, overcharge or ESD events. In such cases, component 720 may correspond to a chip or wireless communication component of the device. Alternatively, the use of VSD material 705 may protect other components from charge that may be caused by the component 720. For example, component 720 may correspond to a battery, and the VSD material 705 may be provided as a trace element on a surface of the substrate 710 to protect against voltage conditions that arise from a battery event.

Any of the embodiments described in U.S. Patent Application No. 11/562,222 (which is incorporated by reference herein) may be implemented with VSD material containing a binder with conductive/semi-conductive high aspect-ratio particles, in accordance with any of the embodiments described herein.

As an alternative or variation, the component 720 may correspond to, for example, a discrete semiconductor device, The VSD material 705 may be integrated with the component, or positioned to electrically couple to the component in the presence of a voltage that switches the material on.

Still further, device 700 may correspond to a packaged device, or alternatively, a semiconductor package for receiving a substrate component. VSD material 705 may be combined with the casing 730 prior to substrate 710 or component 720 being included in the device.

CONCLUSION

Embodiments described with reference to the drawings are considered illustrative, and Applicant's claims should not be limited to details of such illustrative embodiments. Various modifications and variations will may be included with embodiments described, including the combination of features described separately with different illustrative embodiments. Accordingly, it is intended that the scope of the invention be defined by the following claims. Furthermore, it is contemplated that a particular feature described either individually or as part of an embodiment can be combined with other individually described features, or parts of other embodiments, even if the other features and embodiments make no mentioned of the particular feature.

Further aspects are set out in the following numbered clauses.
1. A composition of voltage switchable dielectric material comprising:
   a concentration of high-aspect ratio (HAR) particles, wherein at least a portion of the concentration includes HAR particles that are surface-modified to provide core-shell HAR particles.
2. The composition of clause 1, further comprising:
   a matrix;
   a concentration of conductive and/or semiconductive particles other than the core-shell HAR particles.
3. The composition of clause 2, wherein a combined concentration of the core-shell HAR particles and the conductive and/or semiconductive particles are loaded into the matrix to be at or past a percolation level.
4. The composition of clause 1, wherein individual core-shell HAR particles include a core HAR particle that is formed a nano-dimensioned carbon structures with high aspect ratio.
5. The composition of clause 1, wherein individual core-shell HAR particles include a core HAR particle that is formed from nano-dimensioned metal rods or metal wires.
6. The composition of clause 1, wherein individual core-shell HAR particles include a core HAR particle that is formed from nano-dimensioned conductive metal oxide rods or wires.
7. The composition of clause 1, wherein the shell material includes a nano-dimensioned oxide.
8. The composition of clause 1, wherein the shell material includes a metallic coating.
9. The composition of clause 7, wherein the shell material is selected from a group consisting of titanium dioxide, tin dioxide, antimony doped tin dioxide, zinc oxide, nickel oxide, or copper oxide.
10. The composition of clause 8, wherein the shell materials is selected from a group of metals that have a capability of being electrolessly plated.
11. The composition of clause 10, wherein the shell material corresponds to copper, nickel, or gold.
12. A method for forming VSD material, the method comprising : subjecting a concentration of HAR particles to a medium that activates a surface of individual HAR particle that comprise at least a portion of the concentration; forming a shell material on individually activated HAR particles in the concentration; and forming VSD material using the concentration of HAR particles.
13. The method of clause 12, wherein forming a shell material on individually activated HAR particles includes using a liquid medium.

## Claims

1. A composition comprising:
a matrix;
one or more types of particles dispersed in the matrix, the one or more types of particles including conductor particles, semiconductive particles, and high aspect ratio (HAR) particles that are nano-scaled in at least one dimension;
wherein the matrix and the one or more types of particles combine to provide the composition with a switchable characteristic of (i) being non- conductive in absence of a voltage that is greater than a threshold; and (ii) being conductive in presence of the voltage that is at or greater than the threshold; and
wherein the HAR particles are individually surface-modified to include an activated exterior surface.

2. The composition of claim 1, wherein the HAR particles are surface- modified to include a shell material, so as to provide core-shell HAR particles.

3. The composition of claim 1, wherein the HAR particles include carbon nanotubes.

4. The composition of claim 2, wherein individual core-shell HAR particles include a core HAR particle that is formed from nano-dimensioned metal rods or metal wires.

5. The composition of claim 2, wherein individual core-shell HAR particles include a core HAR particle that is formed from nano-dimensioned conductive metal oxide rods or metal oxide wires.

6. The composition of claim 1, wherein the one or more types of particles are dispersed in the matrix in a concentration that is at or just above a percolation level of the composition.

7. The composition of claim 1, wherein the shell material is one or more of a group comprising:
a semiconductor,
an oxide,
a conductor; and
a metal.

8. The composition of claim 7 or 8, wherein the shell material is a metal that is formed as a shell on the HAR particle through an electroless plating process.

9. The composition of claim 7, wherein the shell material correspond to one of copper, nickel, or gold.

10. The composition of claim 5, wherein the shell material corresponds to an oxide that is formed on the HAR particles by subjecting the HAR particles to an oxide precursor solution.

11. The composition of claim 7, wherein the shell material is selected from a group consisting of titanium dioxide, tin dioxide, antimony doped tin dioxide, zinc oxide, nickel oxide, copper oxide, or combinations thereof.

12. A method for forming VSD material, the method comprising:
subjecting a concentration of HAR particles to a medium that activates a surface of individual HAR particle that comprise at least a portion of the concentration;
forming VSD material using the concentration of HAR particles.

13. The method of claim 12, wherein the HAR particles include carbon nanotubes, and wherein subjecting the concentration to the medium includes subjecting a quantity of carbon nanotubes to an acidic solution.

14. The method of claim 12, wherein subjecting a concentration of HAR particles to a medium includes subjecting the concentration to a precursor that both activates the surface of the individual particles and forms a shell material on individually activated HAR particles in the concentration.
